# EUROPÄISCHE PATENTSCHRIFT

(11) **EP 2 636 054 B1**
(45) Veröffentlichungstag und Bekanntmachung des Hinweises auf die Patenterteilung: **09.03.2016**
(21) Anmeldenummer: 11776715.2
(22) Anmeldetag: 28.10.2011
(51) Int. Cl.: H01J 37/32, C23C 16/44

(54) **VORRICHTUNG ZUM BEHANDELN VON SUBSTRATEN**
APPARATUS FOR TREATMENT OF SUBSTRATES
DISPOSITIF DE TRAITEMENT DE SUBSTRATS

(30) Priorität: 02.11.2010 DE 102010050258
(43) Veröffentlichungstag der Anmeldung: 11.09.2013
(73) Patentinhaber: HQ-Dielectrics GmbH, 89156 Dornstadt (DE)
(72) Erfinder: GSCHWANDTNER, Alexander, 80687 München (DE); NIESS, Jürgen, 89567 Sontheim (DE); BECKMANN, Wilhelm, 33098 Paderborn (DE)
(74) Vertreter: Klang, Alexander H.
(86) Internationale Anmeldenummer: PCT/EP2011/005461
(87) Internationale Veröffentlichungsnummer: WO 2012/059203

(56) Entgegenhaltungen:
- EP-A1- 1 111 658
- WO-A1-2009/060756
- DE-C1- 19 503 205
- JP-A- 2004 319 871
- US-B1- 6 192 603

## Beschreibung

Die vorliegende Erfindung betrifft eine Vorrichtung zum Behandeln von Substraten mit einem Gehäuse, das im Inneren eine Prozesskammer bildet. Insbesondere bezieht sich die Erfindung auf eine Vorrichtung zum thermischen Behandeln von Substraten und/oder eine Vorrichtung zum Behandeln von Substraten mittels eines Plasmas. Eine Vorrichtung sowohl zum thermischen Behandeln von Substraten als auch zum Behandeln von Substraten mittels eines Plasmas ist beispielsweise aus der DE 10 2008 036766 A1 bekannt. Die dort dargestellte Vorrichtung besitzt ein Gehäuse, das im Inneren eine Prozesskammer zur Aufnahme eines zu behandelnden Substrats aufweist. In der Prozesskammer ist eine Vielzahl von Durchgangsöffnungen im Gehäuse vorgesehen. So sind zum Beispiel in gegenüberliegenden Seitenwänden des Prozesskammergehäuses jeweils Durchgangsöffnungen zur Durchführung von Rohrelementen, die nachfolgend auch als Hüllrohre bezeichnet werden, beispielsweise aus Quarz oder Aluminiumoxid (zum Beispiel Saphir) aufgenommen. Die Hüllrohre sind über nicht näher dargestellte Dichtungen so im Gehäuse gehalten, dass die Prozesskammer gegenüber der Umgebung und den Hüllrohren isoliert ist, und zwar auch dann, wenn der Prozessraum auf einen Unterdruck abgepumpt ist.

In den Hüllrohren können dann von außen Heizelemente wie beispielsweise Halogen oder Bogenlampen und/oder Mikrowellenelektroden eingeführt werden, um ein im Prozessraum aufgenommenes Substrat behandeln zu können. Die Elemente können jeweils von der einen oder der anderen Seite oder auch alternierend eingesetzt werden, und es ist auch möglich sie von der einen, der anderen oder auch von beiden Seiten (oder auch alternierend von der einen und der anderen Seite) zu kontaktierten.

Eine solche Behandlung erfolgt in der Regel unter einer genau kontrollierten Prozessgasatmosphäre, und insbesondere bei einer Plasmabehandlung können Radikale, Ionen oder andere reaktive Spezies erzeugt werden. Die Prozessgase, und insbesondere hieraus erzeugte Radikale, Ionen oder andere reaktive Spezies, können jedoch die Dichtungen im Bereich der Durchgangsöffnungen im Gehäuse angreifen, wodurch einerseits die Effektivität der Abdichtung leiden kann, und andererseits unerwünschte Verunreinigungen entstehen können, was zu verkürzten Serviceintervallen und erhöhten Kosten führt.

Ferner sei auf die JP 2004 319 871 A hingewiesen, aus der eine Vorrichtung zum Behandeln von Substraten mit einem Prozesskammergehäuse zur Bildung einer Prozesskammer bekannt ist. Das Prozesskammergehäuse besitzt eine obere Öffnung, die durch eine Platte aus dielektrischem Material abgedeckt ist, um eine Trennung gegenüber einer Mikrowelleneinheit, die in die Prozesskammer einstrahlt, vorzusehen. Die Platte liegt auf einem Auflageflansch des Prozesskammergehäuses auf und zwischen der Platte und dem Auflageflansch ist eine Dichtungsanordnung vorgesehen. Im Bereich des Auflageflansches ist zwischen der Dichtungsanordnung und der Prozesskammer eine Gaseinleitung vorgesehen. Die DE 195 03 205 zeigt eine Vorrichtung zur Erzeugung von Plasma in einem Unterdruckbehälter mit Hilfe von elektromagnetischen Wechselfeldern, wobei ein stabförmiger Leiter innerhalb eines Rohres aus isolierendem Werkstoff durch den Unterdruckbehälter geführt ist, wobei der Innendurchmesser des Rohres größer als der Durchmesser des Leiters ist, und wobei das Rohr an beiden Enden durch Wände des Unterdruckbehälters gehalten und gegenüber den Wänden an seiner Außenfläche abgedichtet ist. Der Leiter ist an beiden Enden an Quellen zur Erzeugung der elektromagnetischen Wechselfelder angeschlossen. Die WO 2009 060 756 A1 zeigt eine Plasma-Behandlungsvorrichtung mit einer Abdichteinheit, bei der zwei beabstandete Dichtungen kreisförmig an einer Kontaktfläche zwischen einem vorstehenden Teil eines Behandlungsgefäßes und einem vorstehenden

Teil eines Deckels vorgesehen sind. Ferner ist ein Gasströmungseinlass für den Zwischenraum zwischen den Dichtungen vorgesehen. Die US 6 192 603 B1 zeigt eine weitere Plasma-Behandlungsvorrichtung bei der Magnetabdichtung für ein Drehlager vorgesehen ist. Aus der EP 1 111 658 A1 ist eine weitere Plasma-Behandlungsvorrichtung bekannt.

Ausgehend von dem oben genannten Stand der Technik liegt der vorliegenden Erfindung daher die Aufgabe zugrunde, eine Vorrichtung zum Behandeln von Substraten des oben genannten Typs zu schaffen, bei dem ein Kontakt zwischen den Dichtungselementen und reaktiven Prozessgaskomponenten verhindert oder reduziert wird. Reaktive Prozessgaskomponenten bezeichnen insbesondere solche Prozessgaskomponenten, welche die Dichtungen angreifen und/oder Abscheidungen im Bereich des Gaseinlasses verursachen und zur Generation von Partikeln und anderen Kontaminationen führen können. Reaktive Prozessgaskomponenten können insbesondere am Substrat durch thermische, chemische Veränderung eines Prozessgases, durch Plasmaprozesse z.B. zur Ätzung- und/oder Schichtabscheidung entstehen und/oder durch getrennt in die Prozesskammer eingeleitete, miteinander reagierende Gase entstehen. Als Beispiele sind Ozon Prozesse oder thermisch generierte Plasmaprozesse angedacht oder auch die Verwendung von korrosiven Prozessgasen (z.B. HCl, NH₃ oder NₓO_{y}).

Erfindungsgemäß wird diese Aufgabe durch eine Vorrichtung nach Anspruch 1 gelöst. Weitere Ausgestaltungen der Erfindung ergeben sich aus den Unteransprüchen.

Insbesondere ist eine Vorrichtung zum Behandeln von Substraten vorgesehen, die ein Gehäuse besitzt, das im Inneren eine Prozesskammer bildet, die auch als Durchlaufkammer ausgeführt sein kann. Ferner weist die Vorrichtung eine Vielzahl von Durchgangsöffnungen im Gehäuse und wenigstens eine Dichtungsanordnung im Bereich jeder der Durchgangsöffnungen auf, um die Prozesskammer zur Umgebung hin abzudichten. Erfindungsgemäß ist wenigstens ein Gaseinlass benachbart zu jeder der Dichtungsanordnungen vorgesehen, der so angeordnet ist, dass hieraus austretendes Gas zwischen der Dichtung und einem Gas bzw. Gaskomponenten in der Prozesskammer einen Gaspuffer bildet. Dabei weist das Gehäuse wenigstens ein die Prozesskammer radial umgebendes Seitenwandteil aufweist, in dem die Vielzahl der Durchgangsöffnungen und die entsprechenden Gaseinlässe integral ausgebildet sind. Durch die spezielle Anordnung des Gaseinlasses kann die Dichtungsanordnung gegenüber einem Gas in der Prozesskammer und insbesondere gegenüber reaktiven Prozessgaskomponenten, die innerhalb der Prozesskammer entstehen geschützt werden. Der integrale Aufbau vereinfacht wesentlich das Gehäuse und die Installation einer entsprechenden Vorrichtung vor Ort. Dabei kann das für den Gaspuffer verwendete Gas zum Beispiel auch ein Prozessgas sein, das erst innerhalb der Prozesskammer, beispielsweise innerhalb eines Plasmabereichs reaktive Prozessgaskomponenten, wie Radikale, Ionen oder andere Spezies, bildet, deren Kontakt mit der wenigstens einen Dichtungsanordnung vermieden werden sollte. Reaktive Prozessgaskomponenten können auch auf andere Weise entstehen, zum Beispiel durch Vermischung zweier allein nicht reaktive Prozessgase, chemische oder thermische Vorgänge und/oder Ätz- und/oder Abscheidungsvorgänge. Es besteht auch die Möglichkeit ein reaktives Gas über eine separate Gaszufuhr einzulassen und über die hier beschriebene Vorrichtung Inertgas zur Dichtungsspülung zu benutzen. Als Durchgangsöffnung ist hier jede Verbindung zwischen einem Inneren der Prozesskammer und der Umgebung zu sehen, insbesondere die Öffnungen für die Durchführung von Hüllrohren, aber auch zum Beispiel eine Türöffnung zum Be-/Entladen eines Substrats.

Bei einer bevorzugten Ausführungsform der Erfindung öffnet sich der wenigstens eine Gasauslass in wenigstens eine Durchgangsöffnung, um eine entsprechende Spülung im Bereich der Durchgangsöffnung vorzusehen. Eine entsprechende Spülung der Durchgangsöffnung ermöglicht eine besonders leichte Isolation einer im Bereich derselben angeordneten Dichtungsanordnung. Vorzugsweise ist die wenigstens eine Dichtungsanordnung in der Durchgangsöffnung angeordnet, um in diesem Bereich eine gute Umfangsabdichtung derselben vorsehen zu können.

Bei einer Ausführungsform der Erfindung ist wenigstens ein Hüllrohr vorgesehen, das sich durch die Durchgangsöffnung in die Prozesskammer erstreckt, wobei die Dichtungsanordnung zwischen dem Hüllrohr und der Durchgangsöffnung angeordnet ist. Hierdurch wird ein Ringraum zwischen Hüllrohr und Durchgangsöffnung gebildet, der durch die eine entsprechende Gasströmung über den wenigstens einen Gaseinlass leicht gespült werden kann.

Vorzugsweise ist eine Vielzahl von Durchgangsöffnungen mit einer entsprechenden Anzahl von Dichtungsanordnungen vorgesehen. Die Vielzahl von Durchgangsöffnungen mit entsprechenden Gaseinlässen sorgt neben dem Schutz der entsprechenden Dichtungsanordnungen darüber hinaus für eine homogene Gaseinleitung in die Prozesskammer hinein.

Vorzugsweise erstreckt sich wenigstens ein Hüllrohr durch die Prozesskammer und zwei in gegenüberliegenden Gehäusewänden ausgebildeten Durchgangsöffnungen hindurch, um in diesem die Aufnahme einer Behandlungseinheit und gegebenenfalls eine beidseitige Kontaktierung/Halterung derselben zu ermöglichen. Dabei kann zum Beispiel wenigstens eine Plasma- oder Heizeinheit in dem Hüllrohr vorgesehen sein.

Gemäß einer Ausführungsform der Erfindung ist der wenigstens eine Gaseinlass so angeordnet, dass er eine spiralförmige Gasströmung vor der Dichtungsanordnung erzeugt, um einen sicheren Gasvorhang und bevorzugt eine spiralförmig von der Dichtungsanordnung weg verlaufende Gasströmung zu erzeugen.

Vorzugsweise steht die Vielzahl der Gasauslässe über eine umlaufende Ringnut in dem Gehäuse mit einer gemeinsamen Gasversorgung in Verbindung. Eine entsprechende umlaufende Nut in dem Gehäuse vereinfacht wiederum den Gesamtaufbau.

Vorzugsweise ist das Gehäuse aus wenigstens zwei, vorzugsweise drei die Prozesskammer radial umgebenden Wandelementen aufgebaut, wobei wenigstens eine radial umlaufende Dichtungsanordnung zwischen den Wandelementen vorgesehen ist. Zwischen dem wenigstens einen umlaufenden Dichtungselement und der innen liegenden Prozesskammer ist wiederum wenigstens ein Gasauslass vorgesehen, um hierüber ein Gas in den Bereich der Prozesskammer einleiten zu können, um dadurch die hierzu außen liegende Dichtungsanordnung gegenüber einem Prozessgas in der Kammer schützen zu können. Vorzugsweise ist hierbei ein umlaufender Gasauslass vorgesehen, der beispielsweise über eine Ringnut, die die Prozesskammer radial umgibt, erreicht wird. Dabei kann wenigstens eines der Wandelemente eine der oben genannten Durchgangsöffnungen mit wenigstens einem entsprechenden Gaseinlass aufweisen, der beispielsweise auch mit der Ringnut in Verbindung steht, und hierüber mit Gas versorgt wird.

Bei einer Ausführungsform der Erfindung weist die Durchgangsöffnung zwischen der Dichtung und der Prozesskammer einen ersten Bereich mit einem ersten Durchmesser auf und zwischen dem ersten Bereich und der Prozesskammer einen zweiten Bereich mit einem zweiten Durchmesser, wobei der erste Durchmesser größer ist als der zweite Durchmesser, und wobei sich der wenigstens eine Gaseinlass zum ersten Bereich hin öffnet. Hierdurch wird im ersten Bereich ein geringerer Strömungswiderstand gebildet, sodass sich aus dem Gaseinlass austretendes Gas zunächst hier verteilt und eine gleichmäßige Gasbarriereschicht erzeugt und erst dann über den zweiten Bereich zur Prozesskammer hin strömt. Vorzugsweise herrscht in dem ersten Bereich mit geringerem Strömungswiderstand ein mindestens 10% höherer Druck als in der Prozesskammer. Der erste Bereich wird vorzugsweise über eine Umlaufende Nut im Bereich der Durchgangsöffnung gebildet.

Die Erfindung wird nachfolgend unter Bezugnahme auf die Zeichnungen noch näher erläutert; in den Zeichnungen zeigt:
- Fig. 1: eine schematische Schnittansicht durch eine Plasma-Behandlungsvorrichtung ;
- Fig. 2: eine schematische Querschnittsansicht der Plasma-Behandlungsvorrichtung gemäß Figur 1 mit einer um 90 Grad gedrehten Schnittebene;
- Fig. 3a: eine schematische Ansicht von unten auf oberes Gehäuseteil der Plasma-Behandlungsvorrichtung gemäß den Figuren 1 und 2;
- Fig. 3b: eine schematische Ansicht von unten auf oberes Gehäuseteil einer Plasma-Behandlungsvorrichtung mit einer alternativen Anordnung von Plasmaelektroden;
- Fig. 4a: eine vergrößerte schematische Ansicht des durch den Kreis A in Fig. 1 gezeigten Teilbereichs der Plasma-Behandlungsvorrichtung;
- Fig. 4b: eine vergrößerte schematische Ansicht wie in Fig. 4a gemäß einer alternativen Ausführungsform;
- Fig. 5a: eine vergrößerte schematische Schnittansicht entlang der Linie V-V in Fig. 4a;
- Fig. 5b: eine vergrößerte schematische Schnittansicht wie in Fig. 5a, die unterschiedliche Anordnungsmöglichkeiten einer Gasleitung zeigt;
- Fig. 6: eine vergrößerte schematische Schnittansicht durch einen Teil der Plasma-Behandlungsvorrichtung gemäß Fig. 1 im Bereich eines Gaseinlasses;
- Fig. 7: eine schematische Draufsicht auf ein mittleres Gehäusebauteil der Plasma-Behandlungsvorrichtung gemäß Fig. 1;
- Fig. 8: eine schematische Ansicht von unten auf ein oberes Gehäusebauteil der Plasma-Behandlungsvorrichtung gemäß Fig. 1.

In der nachfolgenden Beschreibung verwendete Orts- bzw. Richtungsangaben beziehen sich primär auf die Darstellung in den Zeichnungen und sollten daher nicht einschränkend gesehen werden. Sie können sich aber auch auf eine bevorzugte Endanordnung beziehen.

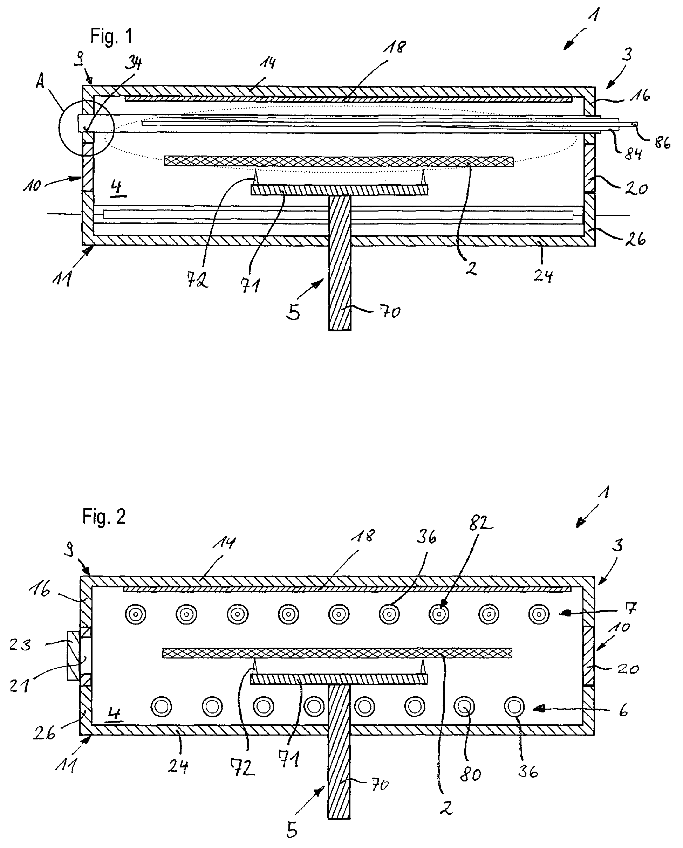

Die Figuren 1 und 2 zeigen jeweils um 90 Grad gedrehte Querschnittsansichten durch eine Plasma-Behandlungsvorrichtung 1 zur Behandlung von flächigen Substraten 2. Die Substrate 2 können dabei insbesondere Halbleitersubstrate sein, deren Oberfläche mittels eines Plasmas geätzt wird oder auf deren Oberfläche ein Schichtwachstum durchgeführt wird. Die Plasma-Behandlungsvorrichtung 1 besteht im Wesentlichen aus einem Gehäuse 3, das im Inneren eine Prozesskammer 4 definiert, einem Gaszuleitungssystem für die Prozesskammer 4, einer Substrataufnahmeeinheit 5, einer Temperieranordnung 6 zum Heizen und/oder Kühlen sowie einer Plasmaanordnung 7.

Das Gehäuse 3 kann irgendeines geeigneten Typs sein, der eine Prozesskammer 4 im Inneren definiert, in der sich über Zu- und Ableitungen vorbestimmte Prozessbedingungen hinsichtlich einer Gaszusammensetzung und Gasdrücken einstellen lässt. Das Substrat kann auch durch das Gehäuse durchgeführt werden, bzw. der Substrathalter kann auch als Heiz oder Kühlelement dienen. In der dargestellten Form wird das Gehäuse 3 speziell durch drei Teile gebildet, nämlich ein oberes Gehäusebauteil 9, ein mittleres Gehäusebauteil 10 und ein unteres Gehäusebauteil 11.

Das obere Gehäusebauteil 9 weist eine Deckplatte 14 und einen umlaufenden Seitenwandteil 16 auf. Die Deckplatte 14 besitzt eine nicht notwendigerweise quadratische Form und der Seitenwandteil 16 folgt dieser und umgibt radial einen oberen Teil der Prozesskammer 4, wie der Fachmann erkennen kann. An einer zur Prozesskammer 4 weisenden Seite der Deckplatte 14 ist ein Abdeckelement 18 vorgesehen, um die Deckplatte 14 gegenüber einem durch die Plasmaanordnung 7 erzeugten Plasma zu schützen.

Der mittlere Gehäuseteil 10 wird durch ein umlaufendes Seitenwandteil 20 gebildet, das dieselbe Umfangsabmessung besitzt wie der umlaufende Seitenwandteil 16 des oberen Seitenwandteils. Der Seitenwandteil 20 umgibt einen mittleren Teil der Prozesskammer, wie der Fachmann erkennen kann. Im Seitenwandteil 20 ist eine Be-/Entladeöffnung 21 vorgesehen (Fig. 2), die über ein bewegliches Türelement 23 verschlossen und geöffnet werden kann. Es können auch zwei Be-/Entladeöffnungen, zum Beispiel in gegenüberliegenden Seitenwandteilen 20 vorgesehen sein, so dass ein kontinuierlicher Transport des Substrates durch die Prozesskammer 4 hindurch möglich ist.

Das untere Gehäusebauteil 11 weist eine Bodenplatte 24 und einen umlaufenden Seitenwandteil 26 auf. Die Bodenplatte 24 besitzt eine quadratische Form und der Seitenwandteil 26 folgt dieser und umgibt radial einen unteren Teil der Prozesskammer 4, wie der Fachmann erkennen kann. Der Seitenwandteil 26 besitzt im Wesentlichen dieselben Umfangsabmessungen wie der umlaufende Seitenwandteil 20 des mittleren Gehäuseteils 10. Im Boden des Gehäuses 3 ist eine Durchführöffnung für eine Tragwelle der Substrathalteanordnung 5 vorgesehen, wie nachfolgend noch näher erläutert wird.

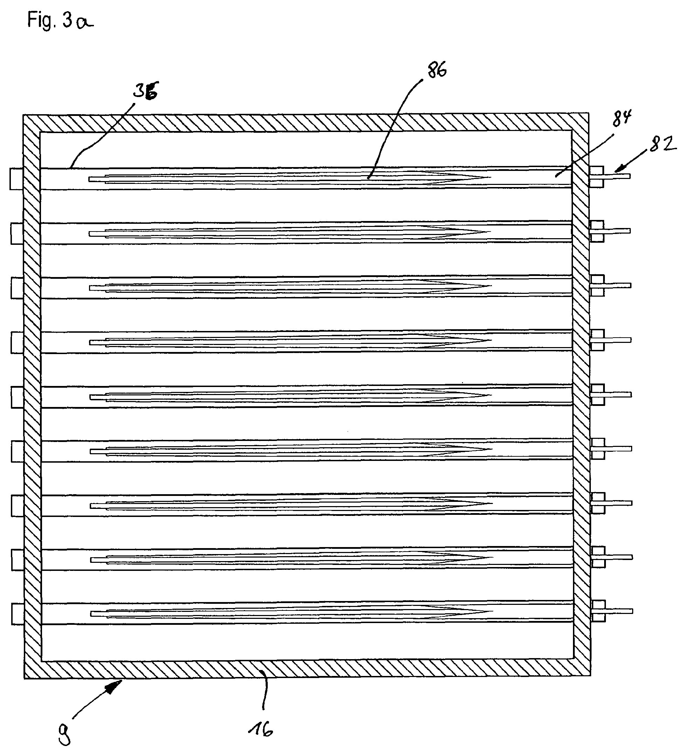

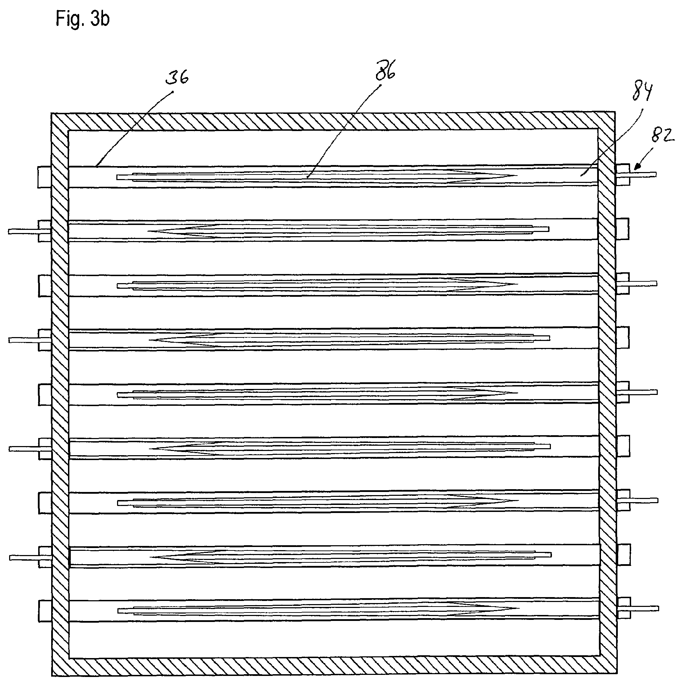

Die Seitenwandteile 16 und 26 des oberen bzw. des unteren Gehäuseteils weisen in gegenüberliegenden Seiten jeweils eine Vielzahl von zueinander weisenden Durchgangsöffnungen 34 auf. Die Durchgangsöffnungen 34 sind jeweils paarweise in gegenüberliegenden Seiten der Seitenwandteile 16 und 26 derart ausgebildet, dass sich ein Hüllrohr 36 durch die Prozesskammer 4 hindurch erstrecken kann, und zwar senkrecht zu den die Durchgangsöffnungen 34 aufweisenden Seiten der Seitenwandteile 16 und 26. Dies ist für den Seitenwandteil 16 des oberen Gehäuseteils 9 am besten in der Darstellung gemäß Fig. 3a oder 3b zu erkennen. Die Hüllrohre 36 dienen wiederum zur Aufnahme von Heiz- oder Plasmaeinheiten, wie nachfolgend noch näher erläutert wird.

Im oberen Gehäuseteil 9 sind neun solcher Paare von Durchgangsöffnungen 34 mit einer entsprechenden Anzahl von darin aufgenommenen Hüllrohren 36 vorgesehen. Im unteren Gehäuseteil 11 sind insgesamt acht Paare von Bohrungen 34 in den gegenüberliegenden Seiten des Seitenwandteils 26 mit einer entsprechenden Anzahl von darin aufgenommenen Hüllrohren 36 vorgesehen.

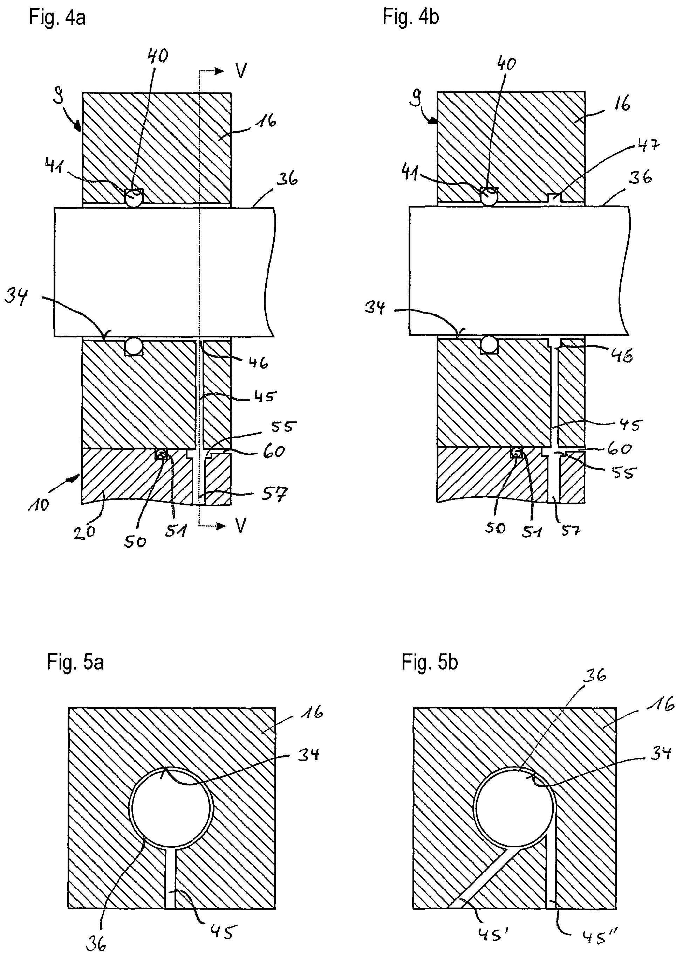

Fig. 4a zeigt eine vergrößerte Schnittansicht durch einen Teilbereich des Gehäuses 3, der durch den Kreis A in Fig. 1 angedeutet ist. Insbesondere zeigt Fig.4 einen Schnitt durch einen Abschnitt des Seitenwandteils 16 des oberen Gehäuseteils 9 im Bereich einer Durchführöffnung 34 und eines benachbarten Abschnitts des Seitenwandteils 20 des mittleren Gehäuseteils 10. In dieser Darstellung ist gut zu erkennen, wie sich das Hüllrohr 36 durch die Durchgangsöffnung 34 hindurcherstreckt. Im Bereich der Durchgangsöffnung ist eine Umfangsnut 40 ausgebildet, in der ein O-Ring 41 aufgenommen ist. Der O-Ring ist zwischen dem Hüllrohr 36 und der Umfangsnut 40 eingeklemmt und dichtet die in Fig. 4a rechts liegende Prozesskammer gegen die in Fig. 4a links liegende Umgebung ab. Natürlich wird der Fachmann erkennen, dass statt eines einfachen O-Rings 41, der in einer Umfangsnut 40 aufgenommen ist, auch eine andere Dichtungsanordnung eingesetzt werden kann, die insbesondere auch aus mehreren gestaffelt angeordneten Dichtungen aufgebaut sein kann.

Ferner ist in Fig. 4a eine Leitung 45 zu erkennen, die sich zwischen einer Unterseite des Seitenwandteils 16 des oberen Gehäuseteils 9 und der Durchgangsöffnung 34 erstreckt. Die Leitung 45 besitzt einen Gasauslass 46, der sich in die Durchgangsöffnung 34 öffnet, und zwar zu einem Bereich der Durchgangsöffnung, der näher an der Prozesskammer 4 liegt als die Dichtungsanordnung bestehend aus dem O-Ring 41. Aus dem Gasauslass 46 austretendes Gas würde den Ringraum zwischen Durchgangsöffnung 34 und Hüllrohr 36 füllen und dadurch zwischen einem Prozessgas in der Prozesskammer 4 und dem O-Ring 41 einen Gaspuffer bilden. Alternativ kann aber für die Ausbildung einer guten Gasbarriereschicht zwischen O-Ring 41 und der Prozesskammer 4 auch noch im Bereich des Gasauslass 46 eine Ringnut 47 vorgesehen sein, wie in Fig. 4b angedeutet ist, die mit der Ausnahme dieser Ringnut 47 der Fig. 4a gleicht. Eine solche Ringnut 47 bietet einem aus dem Gasauslass 46 austretenden Gas einen geringeren Strömungswiderstand als ein Spalt zwischen der Durchgangsöffnung 34 und dem Hüllrohr 36. Somit würde zunächst der Bereich der Ringnut 47 mit Gas gefüllt bevor es in Richtung der Prozesskammer 4 strömen würde. Hierdurch wird eine homogene Ausbildung einer Gasbarriereschicht zwischen dem O-Ring 41 und der Prozesskammer gefördert.

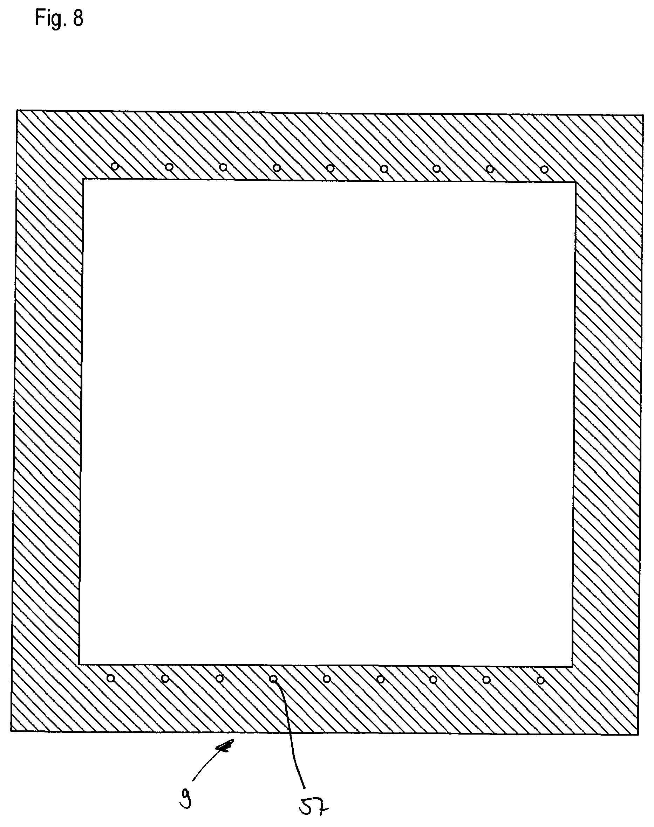

Bei der Darstellung gemäß Fig. 4a und wie auch in der Schnittdarstellung der Fig. 5a zu erkennen ist, erstreckt sich die Leitung 45 vertikal in dem Seitenwandteil 16 und steht mit dem tiefsten Punkt der Durchgangsöffnung 34 in Verbindung. Fig. 5b zeigt hierzu alternative Anordnungsmöglichkeiten dieser Leitung, die mit 45' und 45" gekennzeichnet sind. Die Leitung 45' erstreckt sich schräg zwischen einer Unterseite des Seitenwandteils 16 und dem tiefsten Punkt der Durchgangsöffnung 34. Die Leitung 45" erstreckt sich wiederum vertikal im Seitenwandteil 16, wobei die Leitung 45" die Durchgangsöffnung seitlich schneidet. Aus den Leitungen 45' und 45" austretendes Gas würde daher jeweils eine spiralförmige Gasströmung in dem Ringraum zwischen Durchgangsöffnung 34 und Hüllrohr 36 erzeugen. Fig. 8 zeigt eine Draufsicht auf die Unterseite des oberen Gehäuseteils, in der die Leitungen 45 zu erkennen sind. Diese Ausführungen können natürlich auch mit der Ringnut 47 gemäß Fig. 4b kombiniert werden.

In Fig. 4a ist ferner ein benachbart zum Abschnitt des Seitenwandteils 16 des oberen Gehäuseteils 9 liegender Seitenwandteil 20 des mittleren Gehäuseteils 10 zu erkennen. In einer Oberseite des Seitenwandteils 20 ist eine erste umlaufende Nut 50 ausgebildet, in der eine Dichtung in Form eines O-Rings 51 aufgenommen ist. Der O-Ring 51 dichtet die Kontaktfläche zwischen einander kontaktierenden Stirnflächen der Seitenwandteile 16 und 20 ab. Natürlich kann auch hier eine andere geeignete Dichtungsanordnung anstelle des O-Rings 51 eingesetzt werden.

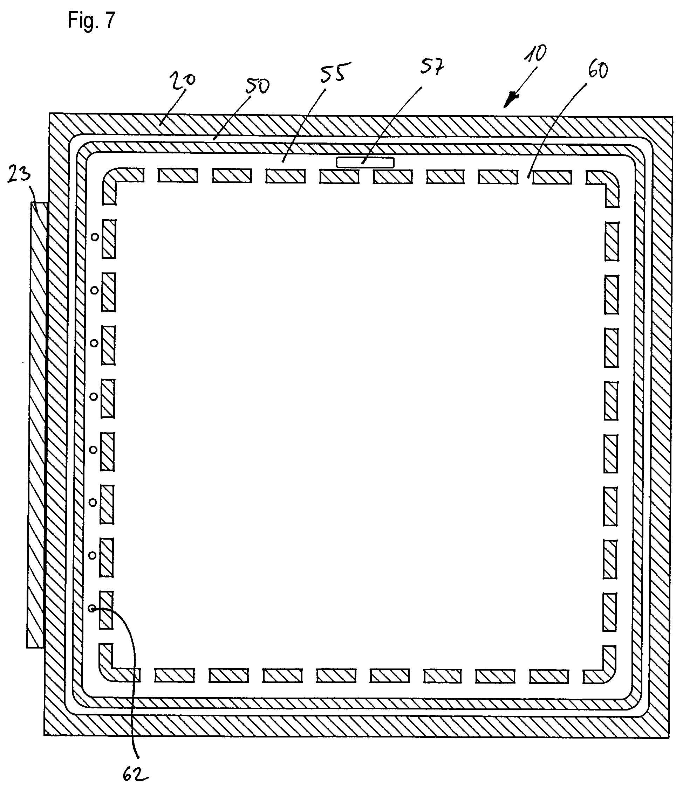

In der Oberseite des Seitenwandteils 20 ist darüber hinaus eine zweite, umlaufende Nut 55 ausgebildet, die mit einem unteren Ende der Leitung 45 im Seitenwandteil 16 des oberen Gehäuseteils 9 ausgerichtet ist, und mit diesem in Strömungsverbindung steht, wie in Fig. 4a zu erkennen ist. Die Umlaufenden Nuten 50 und 55 in der Oberseite des Seitenwandteils 20 sind auch gut in der Draufsicht auf den mittleren Gehäuseteil 10 gemäß Fig. 7 zu erkennen.

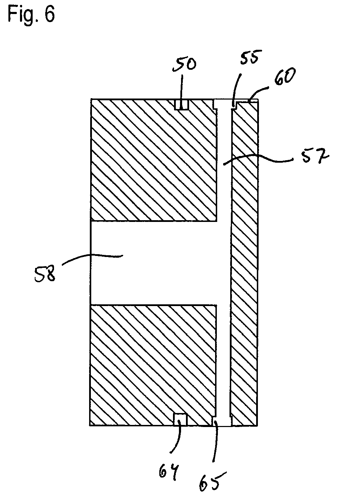

Unterhalb der Nut 55 ist in Fig. 4a ferner eine Leitung 57 zu erkennen, die sich vertikal durch den mittleren Gehäuseteil 10 hindurcherstreckt, und dort mit einer sich horizontal erstreckenden Gaszuleitung 58 in Strömungsverbindung steht, die in Fig. 6 zu erkennen ist. Fig. 6 zeigt dabei eine schematische Schnittansicht durch den mittleren Gehäuseteil 10 im Bereich der Gaszuleitung 58. Wie am besten in den Figuren 4, 6 und 7 zu erkennen ist, ist in der Oberseite des Seitenwandteils 20 des mittleren Gehäuseteils 10 eine Vielzahl von Vertiefungen 60 vorgesehen, die sich zwischen einer zur Prozesskammer 4 weisenden Innenseite des Seitenwandteils 20 und der umlaufenden Nut 55 erstrecken. Diese Vertiefungen sehen eine Strömungsverbindung zwischen der Nut 55 und der Prozesskammer 4 vor. Im Bereich der umlaufenden Nut 55 ist ferner eine Vielzahl von Leitungen 62 (Fig. 7) vorgesehen, die sich von der Nut 55 zur Be-/Entladeöffnung 21 (Fig. 2) erstrecken, um eine Gasströmung von der Nut 55 zur Be-/Entladeöffnung 21 zu ermöglichen und dort einen Gaspuffer zwischen einer Dichtungsanordnung im Bereich des Türelements 23 und der Prozesskammer vorsehen zu können.

An der Unterseite des Seitenwandteils 20 des mittleren Gehäuseteils 9 ist entsprechend der umlaufenden Nut 50 eine umlaufende Nut 64 zur Aufnahme eines O-Rings vorgesehen, sowie eine umlaufende Nut 65, die mit der Leitung 57 in Verbindung steht. Hierzu sei bemerkt, dass die Unterseite des Seitenwandteils 20 des mittleren Gehäuseteils genauso aufgebaut sein kann wie die Oberseite und auch eine Vielzahl von Vertiefungen, wie die Vertiefungen 60 aufweisen kann.

Die oberen und unteren umlaufenden Nuten 55, 65 stehen über die Leitung 57 mit der Gaszuleitung 58 in Strömungsverbindung, wie in Fig. 6 zu erkennen ist. Obwohl die dargestellte Ausführungsform nur eine Gaszuleitung 58 mit entsprechender Verbindungsleitung 57 zu den Nuten 55, 65 zeigt, sei bemerkt, dass mehrere Gaszuleitungen 58 mit entsprechenden Verbindungsleitungen 57 zu den Nuten 55 und 65 vorgesehen sein können.

Der Seitenwandteil 26 des unteren Gehäuseteils 11 kann im wesentlich ähnlich aufgebaut sein, wie der Seitenwandteil 16 des oberen Gehäuseteils 9 mit entsprechenden Durchführöffnungen und Dichtanordnungen, wobei hier nur acht Paare von Durchführöffnungen vorgesehen wären. Natürlich ist die Anzahl der Durchführöffnungen in den oberen und unteren Gehäuseteilen 9, 11 nicht auf die dargestellte Anzahl beschränkt. Ferner wären auch Leitungen vorgesehen, die in diesem Fall eine Oberseite des Seitenwandteils 26 mit jeweiligen Durchführöffnungen verbinden würden, und die mit der unteren umlaufenden Nut 65 im mittleren Gehäuseteil 10 ausgerichtet wären. Hierbei sei bemerkt, dass alternativ oder auch zusätzlich zu den umlaufenden Nuten 55, 65 im mittleren Gehäuseteil 10 auch entsprechende umlaufende Nuten in den Stirnseiten der Seitenwandteile 16, 26 der oberen bzw. unteren Gehäuseteile 9 bzw. 11 bzw. an der Türöffnung vorgesehen sein können.

Im Boden 24 des unteren Gehäuseteils 11 ist eine Durchführöffnung für eine Tragwelle 70 der Substrathalteanordnung 5 vorgesehen. Die Substrathalteanordnung besteht im Wesentlichen aus der sich vertikal erstreckenden Tragwelle 70, einer sich horizontal erstreckenden Tragplatte 71 sowie Auflageelementen 72. Die Tragwelle 70 erstreckt sich durch den Boden 24 und kann außerhalb des Gehäuses 3 zum Beispiel mit einem Antriebsmotor verbunden sein, um die Tragwelle 70 um ihre Längsachse zu drehen und/oder in Vertikalrichtung zu verschieben. Um eine gasdichte Durchführung der Tragwelle 70 durch das Gehäuse 3 zu ermöglichen, können entsprechende Abdichtmechanismen, wie beispielsweise ein Balgenmechanismus im Bereich der Durchführung vorgesehen sein. Die Tragwelle 70 kann beispielsweise aus einem für elektromagnetische Strahlung der Heizanordnung 6 im Wesentlichen transparenten Material, wie beispielsweise Quarz, aufgebaut sein. Alternativ könnte die Tragwelle 70 jedoch auch eine hoch reflektierende Oberfläche aufweisen. Auch diese Dichtung der Tragwelle kann über eine Gasspülung vor reaktiven Prozessgaskomponenten geschützt werden.

Die Tragwelle 70 trägt an ihrem oberen Ende die Tragplatte 71, die über die Tragwelle 70 sowohl in Vertikalrichtung höhenverstellbar ist, als auch um eine Längsachse der Tragwelle 70 drehbar ist. Die Tragplatte 71 ist vorzugsweise aus einem für die elektromagnetische Strahlung der Heizanordnung 6 im Wesentlichen transparenten Material aufgebaut. Auf einer Oberseite der Tragplatte 71 ist eine Vielzahl der Auflageelemente 72 vorgesehen, die wiederum aus einem vorzugsweise für die Strahlung der Heizanordnung 6 transparenten Material aufgebaut ist. Die Auflageelemente 72 sind als konisch spitz zulaufende Kegel dargestellt, auf deren Spitze das Substrat 2 aufliegt. Die Auflageelemente 72 halten das Substrat 2 über einen gewissen Abstand beabstandet zur Tragplatte 71. Die Substrat-Halteanordnung 5 könnte insgesamt auch anders aufgebaut sein. Insbesondere könnte die Tragplatte 71 als sogenannter Suszeptor aufgebaut sein, der eine Projektionsfläche entsprechend dem Substrat 2 aufweist, und mit der Temperieranordnung 6 in elektromagnetischer Wechselwirkung steht, um selbst temperiert zu werden und darüber das Substrat 2 zu temperieren oder selbst eine Temperiereinheit enthält..

Die Temperieranordnung 6, welche hier als Heizanordnung ausgebildet ist, besteht im Wesentlichen aus acht Heizlampen 80, die in den acht Hüllrohren 36 im unteren Bereich der Prozesskammer 4 angeordnet sind. Die Heizlampen 80 sind als Stablampen ausgebildet, die sich im Wesentlichen vollständig durch die Prozesskammer 4 hindurch erstrecken. Die Heizlampen 80 können irgendeines beliebigen Typs sein, der für eine Aufheizung des Substrats 2 mittels elektromagnetischer Strahlung geeignet ist, wie beispielsweise Wolfram-Halogenlampen als Einzelfilament oder Zwillingsfilament oder Doppelfilament. Die Lampen werden im Rohr 36 so gehalten, dass kein Kontakt mit dem Hüllrohr vorliegt. Obwohl dies nicht näher dargestellt ist, können die Hüllrohre 36 mit einem Kühlmedium, wie beispielsweise Luft durchströmt werden, um die Hüllrohre 36 und die Heizlampen 80 während des Betriebs zu kühlen. Dies kann anlog auch für die die Hüllrohre der stabförmigen Plasmaeinheiten erfolgen. Natürlich kann auch eine andere Heizanordnung eingesetzt werden, wie zum Beispiel eine Bogenlampenanordnung oder eine Widerstandsheizeinheit, die zum Beispiel in der Tragplatte 71 integriert sein kann.

Die Plasmaanordnung 7 besteht im Wesentlichen aus einer Vielzahl von stabförmigen Plasmaeinheiten 82. Die Plasmaeinheiten 82 sind jeweils in entsprechenden Quarzröhren 36 aufgenommen, die sich im oberen Bereich der Prozesskammer 4 durch diese hindurch erstrecken. Bei der dargestellten Ausführungsform sind neun Plasmaeinheiten 82 vorgesehen.

Die Plasmaeinheiten 82 können jeweils im Wesentlichen denselben Grundaufbau besitzen, wie er beispielsweise in der DE 10 2008 036 766 A1 beschrieben ist. Dabei besitzen die Plasmaeinheiten jeweils einen Außenleiter 84 sowie einen Innenleiter 86. Der Außenleiter 84 besitzt, wie in der Ansicht von unten gemäß Figur 3a zu erkennen ist, einen Abschnitt, in dem er den Innenleiter 86 vollständig umgibt, sowie einen daran anschließenden geschlitzten Bereich, in dem der Innenleiter 86 allmählich freigelegt wird, bis ein freies Ende des Innenleiters 86 ganz frei liegt. Die Plasmaeinheiten 82 sind jeweils des Typs, der von einer Seite (rechts, siehe Figur 3a) mit Energie beaufschlagt wird. Die Plasmaeinheiten 82 können aber auch um 180 ° gedreht, alternierend (Fig. 3b) oder beliebig eingebaut sein. Auch ist es möglich anderer Plasmaeinheiten einzusetzen, insbesondere Plasmaeinheiten, die beidseitig kontaktiert erden. Am freien Ende des Innenleiters 86 der Plasmaeinheiten ist ferner ein nicht näher dargestellter Resonator vorgesehen, um eine Zündung eines Plasmas im Bereich der Plasmaeinheiten zu fördern.

Für den genauen Aufbau der Plasmaeinheiten wird auf die DE 10 2008 036 766 A1 hingewiesen, die insofern zum Gegenstand der vorliegenden Erfindung gemacht wird, um Wiederholungen zu vermeiden.

Nachfolgend wird nun der Betrieb der Vorrichtung 1 unter Bezugnahme auf die Figuren näher erläutert.

Zunächst wird ein zu behandelndes Substrat 2 in die Prozesskammer 4 geladen und in einer Position gehalten und, wie sie in den Figuren 1 und 2 dargestellt ist. Die Prozesskammer 4 wird über das Türelement 23 verschlossen, und es wird eine gewünschte Gasatmosphäre innerhalb der Prozesskammer 4 eingestellt. Hierzu wird die Prozesskammer zunächst über eine nicht dargestellte Absaugöffnung auf einen Unterdruck abgepumpt. Über die Gaszuleitung 58 und die Leitungen 57 wird dann ein Gas, insbesondere ein Prozessgas in die umlaufenden Nuten 55, 65 geleitet. Von hier gelangt dann ein Teil des Gases über die Vertiefungen 60 in die Prozesskammer. Ein weiterer Teil des Gases wird dann über die Leitungen 62 in den Bereich der Be-/Entladeöffnung 21 und von dort in die Prozesskammer geleitet, wobei die dabei entstehende Gasströmung eine Gasbarriereschicht zwischen der Prozesskammer und dem Türelement bildet, um eine im Bereich des Türelements befindliche Dichtungsanordnung zu schützen. Ein anderer Teil des Gases gelangt über die Leitungen 45 im Seitenwandabschnitt 16 des oberen Gehäuseteils 9 und entsprechende Leitungen im Seitenwandabschnitt des unteren Gehäuseteils in den Bereich der Durchgangsöffnungen. Insbesondere füllt dieses Gas den Ringraum zwischen Durchgangsöffnung 34 und darin aufgenommenen Hüllrohr 36 und sieht somit einen Gaspuffer zwischen Prozessgas in der Prozesskammer und den Dichtungen 41. Wie sich aus der obigen Beschreibung ergibt sind somit unterschiedlichste Dichtungsanordnungen durch eine geschickte Gasführung jeweils gegenüber einem Prozessgas, insbesondere reaktiven Prozessgaskomponenten in der Prozesskammer isoliert. Darüber hinaus sieht die beschriebene Gasführung eine sehr homogene Einleitung des Prozessgases in die Prozesskammer an einer Vielzahl von Punkten vor.

Das Substrat 2 kann in der Prozesskammer 4 über die Temperieranordnung 6 temperiert werden und anschließend kann die Plasmaanordnung 7 gezündet werden, um eine Plasmabehandlung des Substrats in der Prozesskammer zu starten. Beliebige andere Prozessabfolgen sind auch vorstellbar. Während der gesamten Zeit kann die oben beschriebene Gaseinleitung aufrecht erhalten werden, um eine ständige Bildung eines Gaspuffers gegenüber Reaktionsprodukten im Bereich der Prozesskammer und den unterschiedlichen Dichtungsanordnungen vorzusehen.

Die Erfindung wurde zuvor anhand bevorzugter Ausführungsformen näher erläutert, ohne auf die konkret dargestellten Ausführungsformen beschränkt zu sein.

## Patentansprüche

1. Vorrichtung (1) zum Behandeln von Substraten (2) mit einem Gehäuse (3), das im Inneren eine Prozesskammer (4) bildet; einer Vielzahl von Durchgangsöffnungen (34) im Gehäuse (3); wenigstens einer Dichtungsanordnung (40, 41) im Bereich jeder der Durchgangsöffnungen (34), um die Prozesskammer (4) zur Umgebung hin abzudichten; und
wenigstens einem Gaseinlass (46) benachbart zu jeder der Dichtungsanordnungen (40, 41), der so angeordnet ist, dass hieraus austretendes Gas zwischen der jeweiligen Dichtungsanordnung (40, 41) und einem Gas in der Prozesskammer (4) eine Gasbarriereschicht bildet; wobei das Gehäuse (3) wenigstens ein die Prozesskammer (4) radial umgebendes Seitenwandteil (16, 26) aufweist, **gekennzeichnet dadurch dass** die Vielzahl der Durchgangsöffnungen und die entsprechenden Gaseinlässe (46) integral im Seitenwandteil ausgebildet sind.

2. Vorrichtung (1) nach Anspruch 1, wobei sich die Gaseinlässe (46) in eine jeweilige Durchgangsöffnung (34) öffnen, in der eine entsprechende Dichtungsanordnung (40, 41) angeordnet ist.

3. Vorrichtung (1) nach einem der vorhergehenden Ansprüche, wobei wenigstens ein Hüllrohr (36) vorgesehen ist, das sich durch eine der Durchgangsöffnungen (34) in die Prozesskammer (4) erstreckt, und wobei die entsprechende Dichtungsanordnung (40, 41) zwischen dem Hüllrohr (36) und der Durchgangsöffnung (34) angeordnet ist.

4. Vorrichtung (1) nach Anspruch 3, wobei sich wenigstens ein Hüllrohr (36) durch die Prozesskammer (4) und zwei gegenüberliegende Durchgangsöffnungen (34) im Seitenwandteil (16, 26) hindurch erstreckt.

5. Vorrichtung (1) nach Anspruch 3 oder 4, wobei wenigstens eine Plasma- oder Temperiereinheit in dem wenigstens einen Hüllrohr (36) vorgesehen ist.

6. Vorrichtung (1) nach einem der vorhergehenden Ansprüche, wobei der Gaseinlass (46) so angeordnet ist, dass er zwischen Dichtanordnung (40, 41) und Prozesskammer (4) eine spiralförmige Gasströmung erzeugen kann.

7. Vorrichtung (1) nach einem der vorhergehenden Ansprüche, wobei das Gehäuse (3) aus wenigstens zwei, vorzugsweise drei die Prozesskammer (4) radial umgebenden Seitenwandteilen (16, 20, 26) aufgebaut ist, wobei jeweils wenigstens eine radial umlaufende Dichtungsanordnung (50, 51) zwischen Stirnseiten der Seitenwandteile (16, 20, 26) vorgesehen ist, und wobei zwischen der wenigstens einen umlaufenden Dichtungsanordnung (50, 51) und der Prozesskammer (4) wenigstens eine Gasführung (58, 57, 55, 65) vorgesehen ist, welche geeignet ist, eine Gasbarriereschicht zwischen Dichtungsanordnung (50, 51) und Prozesskammer (4) zu bilden.

8. Vorrichtung (1) nach Anspruch 7, wobei wenigstens eine Stirnseite eines Seitenwandteils (16, 20, 26) eine um die Prozesskammer (4) umlaufende Nut (55, 65) aufweist, die über wenigstens eine Leitung (45) mit wenigstens einem der Gaseinlässe (46) in Verbindung steht.

9. Vorrichtung (1) nach Anspruch 8, wobei die Nut (55, 65) einerseits mit einer Gasversorgung in Strömungsverbindung steht und andererseits mit einer Vielzahl der Gaseinlässe (46).

10. Vorrichtung (1) nach einem der vorhergehenden Ansprüche, wobei die Durchgangsöffnungen (34) zwischen der entsprechenden Dichtungsanordnung (40, 41) und der Prozesskammer (4) einen ersten Bereich mit einem ersten Durchmesser aufweisen und zwischen dem ersten Bereich und der Prozesskammer (4) einen zweiten Bereich mit einem zweiten Durchmesser aufweisen, wobei der erste Durchmesser größer ist als der zweite Durchmesser, und wobei sich der wenigstens eine Gaseinlass (46) zum ersten Bereich hin öffnet.

## Claims

1. An apparatus (1) for the treatment of substrates (2), the apparatus having a housing (3), which forms a process chamber (4) in an interior thereof; a plurality of through openings (34) in housing (3);
at least one seal arrangement (40, 41) in the area of each through opening (34), in order to seal the process chamber (4) towards the surrounding environment; and
at least one gas inlet (46) adjacent to each of the seal arrangements (40, 41), the gas inlet (46) being arranged such that gas exiting therefrom forms a gas barrier layer between the respective seal arrangement (40, 41) and a gas in the process chamber (4);
wherein the housing (3) comprises at least one side wall portion (16, 26) radially enclosing the process chamber (4),
**characterized in that** the plurality of the through openings and the respective gas inlets (46) are integrally formed in the side wall portion.

2. Apparatus (1) according to claim 1, wherein the gas inlets (46) open into the respective through opening (34), in which a respective seal arrangement (40, 41) is arranged.

3. Apparatus (1) according to anyone of the preceding claims, wherein at least one jacket tube (36) is provided, which extends through one of the through opening (34) into the process chamber (4), and wherein the respective seal arrangement (40, 41) is arranged between the jacket tube (36) and the through opening (34).

4. Apparatus (1) according to claim 3, wherein at least one jacket tube (36) extends through the process chamber (4) and through two oppositely arranged through openings (34) in the side wall portion (16, 26).

5. Apparatus (1) according to claim 3 or 4, wherein at least on plasma unit or temperature control unit is provided in the at least one jacket tube (36).

6. Apparatus (1) according to anyone of the preceding claims, wherein the gas inlet (46) is arranged such that it may produce a spiral shaped gas flow between the seal arrangement (40, 41) and the process chamber (4).

7. Apparatus (1) according to anyone of the preceding claims, wherein the housing (3) is formed by at least two, preferably three side wall portions (16, 20, 26), which radially encompass the process chamber (4), wherein at least one circumferential sealing arrangement (50, 51) is provided between the small sides of the side wall portions (16, 20, 26), and wherein at least one gas duct (58, 57, 55, 65) is provided between the circumferential seal arrangement (50, 51) and the process chamber (4), which gas duct is configured to form a gas barrier layer between the seal arrangement (50, 51) and the process chamber (4).

8. Apparatus (1) according to claim 7, wherein at least one small side of one of the side wall portion (16, 20, 26) comprises a notch (55, 65) circumferentially arranged with respect to the process chamber (4), which is connected to at least on of the gas inlets (46) via at least one duct (45).

9. Apparatus (1) according to claim 8, wherein the notch (55, 65) on the one hand is fluidly connected to a gas supply and on the other hand to the plurality of gas inlets (46).

10. Apparatus (1) according to anyone of the preceding claims, wherein the through openings (34) comprises a first area having a first diameter between the respective seal arrangement (40, 41) and the process chamber (4) and a second section having a second diameter between the first section and the process chamber (4) wherein the first diameter is larger than the second diameter and wherein the at least one gas inlet (46) opens towards the first section.

## Revendications

1. Dispositif (1) pour le traitement de substrats (2), le dispositif comportant un boîtier (3), qui forme une chambre de traitement (4) à l'intérieur ;
une pluralité d'ouvertures traversantes (34) dans le boîtier (3) ;
au moins un agencement d'étanchéité (40, 41) dans la région de chaque ouverture traversante (34), afin de rendre la chambre de traitement (4) étanche vis-à-vis de l'environnement extérieur ; et
au moins une entrée de gaz (46) adjacente à chacun des agencements d'étanchéité (40, 41), l'entrée de gaz (46) étant agencée de telle sorte que du gaz sortant de celle-ci forme une couche de barrière gazeuse entre l'agencement d'étanchéité (40, 41) respectif et un gaz se trouvant dans la chambre de traitement (4) ;
dans lequel le boîtier (3) comprend au moins une portion de parois latérale (16, 26) enfermant de façon radiale la chambre de traitement (4),
**caractérisé en ce que** la pluralité d'ouvertures traversantes et les entrées de gaz respectives (46) sont formées d'une seule pièce dans la portion de paroi latérale.

2. Dispositif (1) selon la revendication 1, dans lequel chaque entrée de gaz (46) débouche dans l'ouverture traversante (34) respective, dans laquelle un agencement d'étanchéité (40, 41) respectif est réalisé.

3. Dispositif (1) selon l'une quelconque des revendications précédentes, dans lequel au moins un tube de gainage (36) est prévu, qui s'étend à travers l'une des ouvertures traversantes (34) dans la chambre de traitement (4), et dans lequel l'agencement d'étanchéité (40, 41) respectif est réalisé entre le tube de gainage (36) et l'ouverture traversante (34).

4. Dispositif (1) selon la revendication 3, dans lequel au moins un tube de gainage (36) s'étend à travers la chambre de traitement (4) et à travers deux ouvertures traversantes (34) opposées dans la portion de paroi latérale (16, 26).

5. Dispositif (1) selon la revendication 3 ou 4, dans lequel au moins un module plasma ou un module de contrôle de température est prévu dans ledit au moins un tube de gainage (36).

6. Dispositif (1) selon l'une quelconque des revendications précédentes, dans lequel l'entrée de gaz (46) est agencée de telle sorte qu'elle peut produire un flux de gaz en forme de spirale entre l'agencement d'étanchéité (40, 41) et la chambre de traitement (4).

7. Dispositif (1) selon l'une quelconque des revendications précédentes, dans lequel le boîtier (3) est constitué d'au moins deux, de préférence trois, portions de parois latérales (16, 20, 26), qui englobent radialement la chambre de traitement (4), dans lequel au moins un agencement d'étanchéité circonférentiel (50, 51) est prévu entre les petits côtés des portions de parois latérales (16, 20, 26), et dans lequel au moins une conduite de gaz (58, 57, 55, 65) est prévue entre l'agencement d'étanchéité circonférentiel (50, 51) et la chambre de traitement (4), ladite conduite de gaz étant agencée pour former une couche de barrière gazeuse entre l'agencement d'étanchéité (50, 51) et la chambre de traitement (4).

8. Dispositif (1) selon la revendication 7, dans lequel au moins un petit côté de l'une des portions de parois latérales (16, 20, 26) comprend une entaille (55, 65) agencée de façon circonférentielle par rapport à la chambre de traitement (4), qui est connectée à au moins l'une des entrées de gaz (46) par l'intermédiaire d'au moins une conduite (45).

9. Dispositif (1) selon la revendication 8, dans lequel l'entaille (55, 65) est d'une part connectée en termes de fluide à une source d'alimentation en gaz et d'autre part à la pluralité d'entrées de gaz (46).

10. Dispositif (1) selon l'une quelconque des revendications précédentes, dans lequel les ouvertures traversantes (34) comprennent une première région ayant un premier diamètre entre l'agencement d'étanchéité (40, 41) respectif et la chambre de traitement (4), et une deuxième section ayant un deuxième diamètre entre la première section et la chambre de traitement (4), le premier diamètre étant plus grand que le deuxième diamètre, et ladite au moins une entrée de gaz (46) ouvrant en direction de la première section.
